# EUROPÄISCHE PATENTSCHRIFT

(11) **EP 2 091 116 B1**
(45) Veröffentlichungstag und Bekanntmachung des Hinweises auf die Patenterteilung: **08.04.2020**
(21) Anmeldenummer: 09151143.6
(22) Anmeldetag: 22.01.2009
(51) Int. Cl.: H01S 5/02, H01L 33/00, H01L 21/78

(54) **Verfahren zur Herstellung eines Halbleiterlasers sowie Halbleiterlaser**
Method for manufacturing a semiconductor laser and semiconductor laser
Procédé destiné à la fabrication d'un laser semi-conducteur, ainsi que laser semi-conducteur

(30) Priorität: 14.02.2008 DE 102008009108
(43) Veröffentlichungstag der Anmeldung: 19.08.2009
(73) Patentinhaber: OSRAM Opto Semiconductors GmbH, 93055 Regensburg (DE)
(72) Erfinder: Dachs, Jürgen, 85107 Baar - Ebenhausen (DE); Illek, Stefan, 93093 Donaustauf (DE); Singer, Frank, 93128 Regenstauf (DE); Schwarz, Thomas, 93055 Regensburg (DE); Schulz, Roland, 93059 Regensburg (DE); Unold, Heiko, 93073 Neutraubling (DE)
(74) Vertreter: Epping - Hermann - Fischer

(56) Entgegenhaltungen:
- DE-A1-102006 042 196
- JP-A- H03 286 547
- JP-A- 2005 010 435
- US-A1- 2002 090 013
- US-B1- 7 164 702

## Beschreibung

Es wird ein Verfahren zur Herstellung einer Vielzahl von Halbleiterlasern angegeben.

Die Druckschriften JP 2005 010435 A und JP H03 286547 A beschreiben jeweils ein Verfahren zum Aufbringen von Laserchips auf einem Montagebereich.

Eine zu lösende Aufgabe besteht darin, ein Verfahren anzugeben, mit dem besonders kompakte Halbleiterlaser in großer Stückzahl erzeugt werden können. Eine weitere zu lösende Aufgabe besteht darin, einen besonders kompakten Halbleiterlaser anzugeben.

Gemäß zumindest einer Ausführungsform des Verfahrens umfasst das Verfahren einen Verfahrensschritt, bei dem eine Trägerscheibe bereitgestellt wird. Bei der Trägerscheibe handelt es sich um eine Scheibe, welche als Träger für auf die Scheibe aufzubringende Bauelemente dient. Die Trägerscheibe weist eine Oberseite und eine Unterseite auf. Oberseite und Unterseite sind dabei durch Haupterstreckungsebenen der Trägerscheibe gebildet. Die Trägerscheibe zeichnet sich dadurch aus, dass Ober- und Unterseite im Wesentlichen parallel zueinander verlaufen. "Im Wesentlichen parallel zueinander" bedeutet, dass die Abweichung von einem plan-parallelen Verlauf höchstens 0,5 Grad, bevorzugt höchstens 0,3 Grad, besonders bevorzugt höchstens 0,1 Grad beträgt.

Gemäß zumindest einer Ausführungsform des Verfahrens zur Herstellung einer Vielzahl von Halbleiterlasern weist das Verfahren einen Verfahrensschritt auf, bei dem ein Verbund durch das Aufbringen einer Vielzahl von Halbleiterlaserchips auf die Oberseite der Trägerscheibe hergestellt wird. Die Vielzahl von Halbleiterlaserchips wird dabei vorzugsweise mechanisch fest mit der Trägerscheibe verbunden. Bei den Halbleiterlaserchips handelt es sich um optisch pumpbare Halbleiterlaserchips. Das heißt, im Betrieb der Halbleiterlaserchips, werden diese von einer externen oder internen Pumpquelle optisch gepumpt, so dass von den Halbleiterlaserchips elektromagnetische Strahlung erzeugt wird. Vorzugsweise weisen die Halbleiterlaserchips dabei zumindest eine reflektierende Schichtenfolge - vorzugsweise einen Bragg-Spiegel - auf, welcher als Resonatorspiegel dient.

Beispielsweise die Druckschrift WO 02/067393 beschreibt einen oberflächenemittierenden Halbleiterlaserchip mit integrierter Pumpstrahlquelle.

Gemäß zumindest einer Ausführungsform des Verfahrens zur Herstellung einer Vielzahl von Halbleiterlasern weist das Verfahren einen Verfahrensschritt auf, wonach der Verbund aus Halbleiterlaserchips und Trägerscheibe zu einer Vielzahl von Halbleiterlasern vereinzelt wird. Die Vereinzelung des Verbundes erfolgt durch ein Lasertrennverfahren oder ein Wafersägen. Jeder der Vielzahl von Halbleiterlasern umfasst einen Montageblock und zumindest einen Halbleiterlaserchip, welcher auf den Montageblock aufgebracht ist. Der Montageblock ist aus einem Teil der ursprünglichen Trägerscheibe gebildet, welcher durch das Vereinzeln des Verbundes erzeugt ist. Das heißt, auch der Montageblock zeichnet sich dadurch aus, dass seine Oberseite und seine Unterseite im Wesentlichen plan-parallel zueinander verlaufen. Die Oberseite des Montageblocks ist dabei diejenige Seite, auf welche der oder die Halbleiterlaserchips aufgebracht sind. Beispielsweise ist auf jeden Montageblock genau ein Halbleiterlaserchip aufgebracht.

Weiterhin weist jeder Montageblock eine Montagefläche auf. Die Montagefläche verläuft im Wesentlichen senkrecht zur Oberseite des Montageblocks. "Im Wesentlichen senkrecht" heißt dabei, dass der Winkel zwischen Oberseite und Montagefläche einen Winkelfehler von höchstens 0,5 Grad, bevorzugt höchstens 0,4 Grad, besonders bevorzugt von höchstens 0,3 Grad aufweist. Ein solch geringer Winkelfehler ist dabei dadurch realisiert, dass die Montagefläche beim Vereinzeln des Verbundes aus Trägerscheibe und einer Vielzahl von Halbleiterlaserchips erzeugt wird. Das bedeutet, die Montagefläche des Montageblocks ist durch eine Fläche gegeben, entlang der die Trägerscheibe vereinzelt wurde. Die Montagefläche kann daher Vereinzelungsspuren aufweisen. Mit der Montagefläche kann der Montageträger beispielsweise auf einen Modulträger montiert werden.

Gemäß zumindest einer Ausführungsform des Verfahrens zur Herstellung einer Vielzahl von Halbleiterlasern weist das Verfahren die folgenden Verfahrensschritte auf:
a) Bereitstellen einer Trägerscheibe,
b) Herstellen eines Verbunds durch Aufbringen einer Vielzahl von Halbleiterlaserchips auf eine Oberseite der Trägerscheibe,
c) Vereinzeln des Verbunds zu einer Vielzahl von Halbleiterlasern, wobei jeder Halbleiterlaser einen Montageblock und zumindest einen Halbleiterlaserchip umfasst, jeder Montageblock eine Montagefläche aufweist, die im Wesentlichen senkrecht zu einer Oberseite des Montageblocks verläuft, auf welcher der Halbleiterlaserchip angeordnet ist, und wobei die Montagefläche beim Vereinzeln des Verbunds erzeugt wird.

Mit dem hier beschriebenen Verfahren ist es auch möglich, anstatt einen Halbleiterlaser andere optoelektronische Halbleiterbauelemente wie Leuchtdioden oder Fotodioden herzustellen. Das heißt, das beschriebene Verfahren ist allgemein für eine Herstellung optoelektronischer Halbleiterbauelemente offenbart. In einer Ausführungsform kann das Verfahren dann die folgenden Schritte aufweisen:
a) Bereitstellen einer Trägerscheibe
b) Herstellen eines Verbunds durch Aufbringen einer Vielzahl von Halbleiterchips auf eine Oberseite der Trägerscheibe,
c) Vereinzeln des Verbundes zu einer Vielzahl von optoelektronischen Halbleiterbauelementen, wobei
   - jedes Halbleiterbauelement einen Montageblock und zumindest einen Halbleiterchip umfasst,
   - jeder Montageblock eine Montagefläche aufweist, die im Wesentlichen senkrecht zu einer Oberseite des Montageblocks verläuft, auf welcher der Halbleiterchip angeordnet ist, und
   - die Montagefläche beim Vereinzeln des Verbunds erzeugt wird.

Bei den Halbleiterchips kann es sich dann zum Beispiel um Leuchtdiodenchips oder um Fotodiodenchips handeln.

Gemäß zumindest einer Ausführungsform des hier beschriebenen Verfahrens enthält die Trägerscheibe oder besteht die Trägerscheibe aus einem der folgenden Materialien:
Halbleitermaterial, Keramikmaterial. Vorzugsweise besteht die Trägerscheibe aus einem nicht-metallischen Material.
Beispielsweise besteht die Trägerscheibe aus Silizium oder Aluminiumnitrid (AlN). Es erweist sich dabei für das Verfahren als besonders vorteilhaft, wenn die Trägerscheibe aus einem Halbleitermaterial und/oder aus einem Keramikmaterial besteht, da sich solche Materialien in Halbleiterprozessen besonders gut trennen lassen. Auf diese Weise kann in einfacher Art eine Vielzahl von Halbleiterlasern durch Vereinzelung der Trägerscheibe erzeugt werden. Die beschriebenen Materialien für die Trägerscheibe erweisen sich bei der Herstellung einer Vielzahl von Halbleiterlasern gegenüber beispielsweise einer Trägerscheibe, welche aus Metall besteht, als besonders vorteilhaft, da solch eine Metallscheibe nur schwer oder gar nicht in der beschriebenen Art und Weise vereinzelt werden kann.

Ferner sind für die beschriebenen Materialien winkelgenaue Trenntechniken wie zum Beispiel Lasertrennverfahren oder Wafersägen vorhanden. Gegebenenfalls kann nach der Vereinzelung ein Polieren der Montageflächen der erzeugten Montageblocks erfolgen, um möglichst einen genauen 90 Grad Winkel zwischen der Oberseite des Montageblocks und der Montagefläche zu erzeugen. Ferner können aus den beschriebenen nicht-metallischen Materialien wie Halbleitermaterial und Keramikmaterial große Trägerscheiben erzeugt werden, welche eine hohe Plan-Parallelität zwischen ihrer Ober- und Unterseite aufweisen. Die Verwendung einer Trägerscheibe ermöglicht ferner, dass das Verfahren im Nutzen durchgeführt wird. Herstellung "im Nutzen" heißt dabei, dass eine Vielzahl identischer Halbleiterlaser auf ein und derselben Trägerscheibe gefertigt werden.

Gemäß zumindest einer Ausführungsform des Verfahrens zur Herstellung einer Vielzahl von Halbleiterlasern werden die Halbleiterlaserchips bei der Herstellung des Verbundes der Vielzahl von Halbleiterlaserchips und der Trägerscheibe einzeln auf die Oberseite der Trägerscheibe aufgebracht. Das heißt, die Halbleiterlaserchips sind vor dem Aufbringen auf die Trägerscheibe bereits vereinzelt und werden an dafür vorgesehenen Stellen auf die Trägerscheibe aufgebracht. Dabei werden die Halbleiterlaserchips vorzugsweise an Gitterpunkten eines regelmäßigen Gitters platziert, so dass auf der Oberseite der Trägerscheibe ein regelmäßiges Muster von Halbleiterlaserchips entsteht. Beispielsweise werden die Halbleiterlaserchips an den Gitterpunkten eines gedachten Rechteckgitters platziert, so dass die Halbleiterlaserchips nach Art einer Matrix in Zeilen und Spalten auf der Oberseite der Trägerscheibe angeordnet sind.

Gemäß einem alternativen Verfahrensschritt werden die Halbleiterlaserchips bei der Herstellung des Verbundes aus der Vielzahl von Halbleiterlaserchips und der Trägerscheibe im Wafer-Verbund auf die Oberseite der Trägerscheibe aufgebracht. "Im Wafer-Verbund" heißt dabei, dass die Halbleiterlaserchips noch nicht vereinzelt sind, sondern sich beispielsweise noch in dem Wafer-Verbund befinden, in welchem sie hergestellt wurden. Der Wafer-Verbund kann dabei beispielsweise einen Substrat-Wafer umfassen, auf welchen eine Schichtenfolge, welche die laseraktive Schicht umfasst, epitaktisch abgeschieden ist. Der Wafer-Verbund von Halbleiterlaserchips weist dabei vorzugsweise in etwa die gleiche Form und Größe wie die Trägerscheibe auf. Auf diese Weise kann der Verbund aus der Vielzahl von Halbleiterlaserchips und der Trägerscheibe durch Übereinanderlegen und Verbinden von Trägerscheibe und Wafer-Verbund erzeugt werden.

Gemäß zumindest einer Ausführungsform des hier beschriebenen Verfahrens wird nach dem Aufbringen des Wafer-Verbunds das Wachstumssubstrat von den Halbleiterlaserchips entfernt. In dieser Ausführungsform handelt es sich bei den Halbleiterlaserchips um so genannte "Bottom-Emitter" Strukturen. Auf der der Trägerscheibe gegenüberliegenden Seite des Wafer-Verbunds der Halbleiterlaserchips wird das Wachstumssubstrat entfernt, so dass die Halbleiterlaserchips als Dünnfilm-Halbleiterlaserchips vorliegen. Alternativ zu einem vollständigen Entfernen des Wachstumssubstrats ist es auch möglich, dass das Wachstumssubstrat gedünnt wird oder nur stellenweise entfernt wird. Wird das Wachstumssubstrat nur stellenweise entfernt, wird es vorzugsweise dort entfernt, wo Laserstrahlung im Betrieb aus den Halbleiterlaserchips austritt.

Gemäß zumindest einer Ausführungsform des Verfahrens wird vor der Herstellung des Verbunds für jeden Halbleiterlaserchip eine Kontaktmetallisierung auf der Oberseite der Trägerscheibe aufgebracht. Bei der Kontaktmetallisierung kann es sich beispielsweise um rechteckige TiPtAu-Kontaktflächen handeln. Dabei ist es auch möglich, dass eine Kontaktmetallisierung ganzflächig auf die Oberseite der Trägerscheibe aufgebracht wird und eine Strukturierung der Kontaktmetallisierung in einzelne Kontaktflächen erst durch das Vereinzeln des Verbunds zu einer Vielzahl von Halbleiterlasern erfolgt.

Gemäß zumindest einer Ausführungsform des Verfahrens wird vor dem Herstellen des Verbunds für jeden Halbleiterlaserchip eine Wärmesenke auf die Oberseite der Trägerscheibe aufgebracht.

Die Wärmesenke enthält oder besteht zum Beispiel aus einem der folgenden Materialien: AlN, SiC, Diamant, Kupfer.

Die Wärmesenke verbessert dabei den Abtransport der im Betrieb erzeugten Wärme vom Halbleiterlaserchip. Der Halbleiterlaserchip wird dann auf die der Trägerscheibe abgewandten Oberfläche der Wärmesenke aufgebracht. Dabei ist es auch möglich, dass eine Wärmesenkescheibe großflächig auf die Oberseite der Trägerscheibe aufgebracht wird und einzelne Wärmesenken erst mit der Vereinzelung des Verbundes zu einzelnen Halbleiterlaserchips erzeugt werden.

Darüber hinaus wird ein Halbleiterlaser angegeben.

Gemäß zumindest einer Ausführungsform des Halbleiterlasers umfasst der Halbleiterlaser einen Montageblock. Bei dem Montageblock handelt es sich um einen Träger, auf welchem zumindest ein Halbleiterlaserchip aufgebracht ist. Der Montageblock umfasst eine Oberseite und eine Montagefläche. Auf die Oberseite des Montageblocks ist zumindest ein Halbleiterlaserchip aufgebracht. Dabei verläuft die Montagefläche im Wesentlichen senkrecht zur Oberseite des Montageblocks. "Im Wesentlichen senkrecht" heißt dabei, dass der Winkel zwischen Oberseite und Montagefläche einen Winkelfehler von höchstens 0,5 Grad, bevorzugt höchstens 0,4 Grad, besonders bevorzugt von höchstens 0,3 Grad aufweist.

Gemäß zumindest einer Ausführungsform des Halbleiterlasers ist die Montagefläche durch einen Vereinzelungsprozess erzeugt. Das heißt, die Montagefläche ist durch Vereinzelung einer größeren Struktur - etwa einer Trägerscheibe - zum Montageblock erzeugt. Die Montagefläche weist daher Vereinzelungsspuren auf. Das heißt, die Montagefläche ist nicht durch einen anderen Formungsprozess wie epitaktisches Wachstum, Spritzgussverfahren oder Spritzpressverfahren hergestellt, sondern durch einen Vereinzelungsprozess wie Sägen oder Lasertrennen erzeugt.

Gemäß zumindest einer Ausführungsform des Halbleiterlasers umfasst der Halbleiterlaser einen Montageblock, der eine Oberseite und eine Montagefläche aufweist. Ferner umfasst der Halbleiterlaser zumindest einen Halbleiterlaserchip, der auf der Oberseite des Montageblocks angeordnet ist. Dabei verläuft die Montagefläche im Wesentlichen senkrecht zur Oberseite des Montageblocks und die Montagefläche ist durch einen Vereinzelungsprozess erzeugt.

Gemäß zumindest einer Ausführungsform des Halbleiterlasers ist der Halbleiterlaser durch ein Verfahren wie es in Verbindung mit zumindest einer Ausführungsform der hier beschriebenen Verfahren zur Herstellung einer Vielzahl von Halbleiterlasern beschrieben ist, herstellbar oder hergestellt.

Gemäß zumindest einer Ausführungsform des Halbleiterlasers enthält oder besteht der Montageblock aus einem nicht-metallischen Material wie etwa einem der folgenden Materialien: Halbleitermaterial, Keramikmaterial. Der Montageblock besteht dabei beispielsweise aus Silizium oder Aluminiumnitrid.

Gemäß zumindest einer Ausführungsform des Halbleiterlasers weist der Montageblock eine im Wesentlichen gleichmäßige Dicke auf. Die Dicke des Montageblocks ist dabei der Abstand von seiner Oberseite, auf welche der Halbleiterlaserchip aufgebracht ist zu seiner Unterseite, welche der Oberseite gegenüberliegend angeordnet ist. Ober- und Unterseite verlaufen vorzugsweise parallel oder im Wesentlichen parallel, derart dass die Abweichung von einem parallelen Verlauf höchstens 0,5 Grad, bevorzugt höchstens 0,3 Grad, besonders bevorzugt höchstens 0,1 Grad beträgt.

Die Dicke beträgt dabei vorzugsweise wenigstens 0,5 mm und höchstens 1,7 mm, besonders bevorzugt wenigstens 0,6 mm und höchstens 1,5 mm.

Im Folgenden wird das hier beschriebene Verfahren und sowie der hier beschriebene Halbleiterlaser anhand von Ausführungsbeispielen und den dazugehörigen Figuren näher erläutert.
- Die Figuren 1A bis 1D: zeigen in schematischen Perspektivdarstellungen ein erstes Ausführungsbeispiel eines hier beschriebenen Verfahrens zur Herstellung einer Vielzahl von Halbleiterlasern.
- Die Figuren 2A bis 2D: zeigen in schematischen Perspektivdarstellungen ein zweites Ausführungsbeispiel eines hier beschriebenen Verfahrens zur Herstellung einer Vielzahl von Halbleiterlasern.
- Die Figuren 3A und 3B: zeigen ein Ausführungsbeispiel eines hier beschriebenen Halbleiterlasers.
- Die Figuren 4A bis 4C: zeigen einen möglichen Einsatz eines hier beschriebenen Halbleiterlasers in einem Halbleiterlasermodul.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

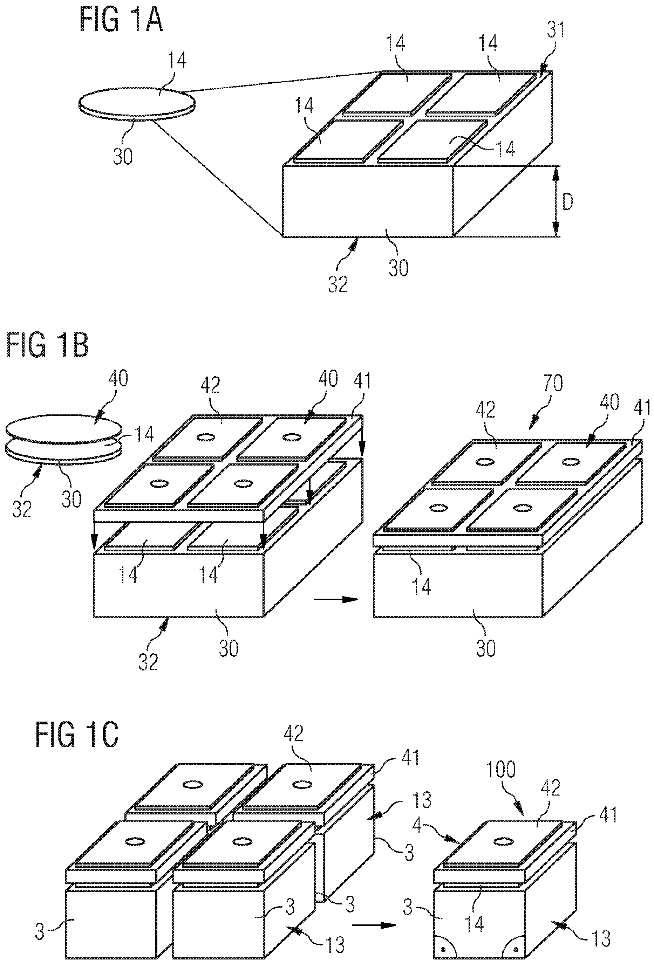

Die Figuren 1A bis 1D zeigen in schematischen Perspektivdarstellungen ein erstes Ausführungsbeispiel eines hier beschriebenen Verfahrens zur Herstellung einer Vielzahl von Halbleiterlasern.

Die Figur 1A zeigt in einer schematischen Perspektivdarstellung einen ersten Verfahrensschritt zur Herstellung einer Vielzahl von Halbleiterlasern. In diesem ersten Verfahrensschritt wird zunächst eine Trägerscheibe 30 bereitgestellt. Die Trägerscheibe 30 besteht aus Silizium oder Aluminiumnitrid. Die Trägerscheibe 30 weist eine gleichmäßige Dicke D auf. Die Dicke liegt dabei vorzugsweise zwischen 0,6 mm und 1,5 mm. Die Trägerscheibe umfasst eine Oberseite 31 und eine Unterseite 32. Oberseite 31 und Unterseite 32 der Trägerscheibe 30 verlaufen im Wesentlichen plan-parallel zueinander. Das heißt, die Abweichung von der Plan-Parallelität beträgt vorzugsweise weniger als 0,1 Grad. Die Figur 1A zeigt dabei links die gesamte Trägerscheibe sowie rechts einen vergrößert dargestellten Ausschnitt aus der Trägerscheibe.

Auf die Oberseite 31 der Trägerscheibe ist eine Kontaktmetallisierung 14 aufgebracht, welche durch rechteckige TiPtAu-Kontaktflächen gebildet ist. Die Kontaktmetallisierung dient einem späteren mechanischen Befestigen von Halbleiterlaserchips.

In Verbindung mit der Figur 1B ist anhand schematischer Perspektivzeichnungen ein weiterer Verfahrensschritt zur Herstellung einer Vielzahl von Halbleiterlasern gemäß dem ersten Ausführungsbeispiel beschrieben. In diesem Verfahrensschritt wird ein Wafer-Verbund 40 von Halbleiterlaserchips 4 auf die Trägerscheibe 30 aufgebracht. Der Wafer-Verbund 40 weist dabei auf seiner der Trägerscheibe 30 zugewandten Seite eine Lotmetallisierung auf, welche in den Figuren nicht dargestellt ist.

Als Lotmetallisierung kann zum Beispiel ein AuSn-Lot zum Einsatz kommen. Es sind aber auch andere Lotmaterialien denkbar. Ferner sind alternative Verbindungstechniken wie Kleben zum Verbinden von Halbleiterlaserchips 4 und Trägerscheibe 30 möglich.

Der Wafer-Verbund 40 von Halbleiterlaserchips besteht dabei beispielsweise aus einem Aufwachssubstrat 41, auf das epitaktisch abgeschiedene Schichten 42 aufgebracht sind. Die epitaktisch abgeschiedenen Schichten 42 umfassen dabei unter anderem aktive Schichten, welche zur Erzeugung von Laserstrahlung geeignet sind.

Der Wafer-Verbund wird mit einer Genauigkeit von wenigen Mikrometern auf die Trägerscheibe 30 aufgebracht. Anschließend wird die Lotmetallisierung des Wafer-Verbunds mit der Kontaktmetallisierung 14 verlötet, so dass eine mechanisch feste Verbindung, also ein Verbund 70 von Wafer-Verbund 40 und Trägerscheibe 30 erzeugt wird.

Vorzugsweise ist auf der dem Wafer-Verbund 40 abgewandten Unterseite 32 der Trägerscheibe 30 eine klebende Sägefolie aufgebracht, welche in einem Rahmen eingespannt ist.

In Verbindung mit der Figur 1C ist in einer schematischen Perspektivdarstellung ein weiterer Verfahrensschritt des Verfahrens gemäß dem ersten Ausführungsbeispiel beschrieben. In diesem Verfahrensschritt wird der Verbund aus Wafer-Verbund 40 und Trägerscheibe 30 zu einzelnen Halbleiterlasern 100 umfassend einen Montageblock und einen Halbleiterlaserchip 4 vereinzelt. Die Vereinzelung kann beispielsweise durch ein Lasertrennverfahren oder Wafersägen erfolgen. Nach dem Sägen wird die Sägefolie, auf welche der Verbund 70 aufgebracht ist, expandiert. Auf diese Weise trennen sich die einzelnen Chips entlang der Vereinzelungslinien voneinander. Durch das Vereinzeln werden Montageflächen 13 einzelner Montageblocks 3 erzeugt. Aufgrund des verwendeten Materials für die Trägerscheibe 30 und des verwendeten Vereinzelungsprozesses sind die Montageflächen 13 sehr eben ausgebildet und weisen höchstens einen geringen Winkelfehler gegen die Senkrechte zur Oberseite des Montageblocks 3 auf. Der Winkelfehler beträgt dabei weniger als 0,3 Grad.

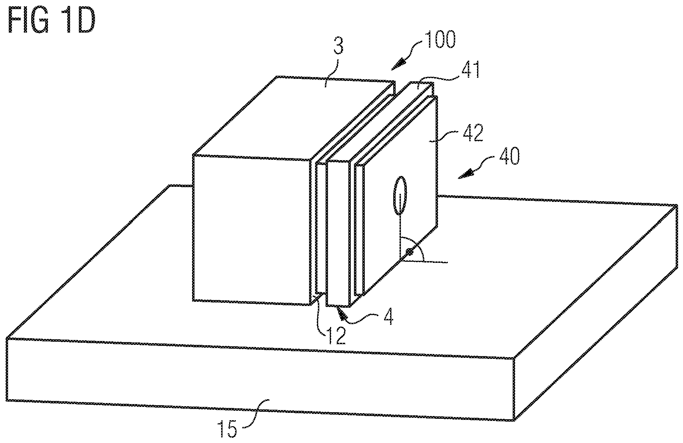

Die Figur 1D zeigt in einer schematischen Perspektivdarstellung einen gemäß dem ersten Ausführungsbeispiel hergestellten Halbleiterlaser 100, welcher mit seiner Montagefläche 13 auf einen Modulträger 15 montiert ist. Wie aus der Figur 1D ersichtlich, bilden - aufgrund des geringen Winkelfehlers - die dem Modulträger 3 abgewandte Oberseite des Halbleiterlaserchips 4 sowie die Montagefläche des Modulträgers 15 einen rechten Winkel miteinander.

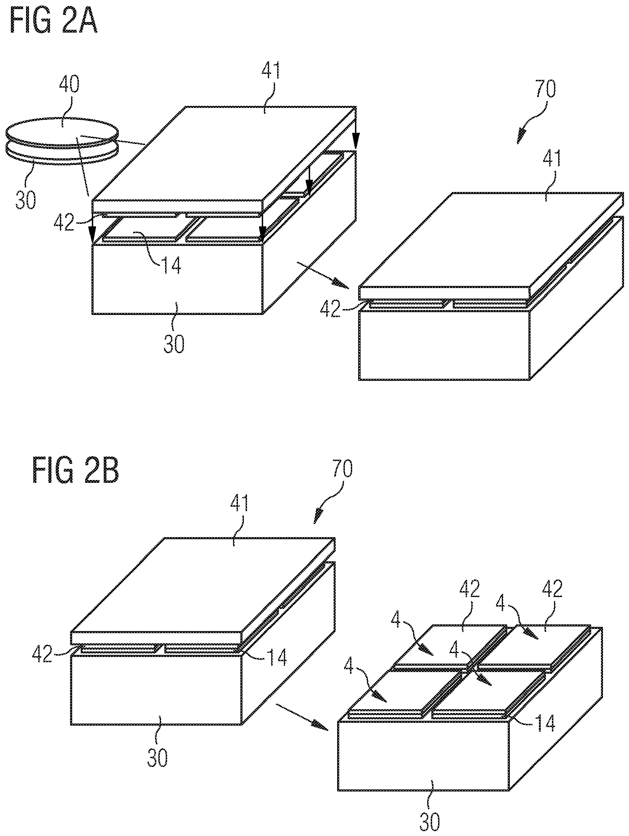

In Verbindung mit den Figuren 2A bis 2D ist anhand schematischer Perspektivdarstellungen ein zweites Ausführungsbeispiel eines hier beschriebenen Verfahrens zur Herstellung einer Vielzahl von Halbleiterlasern beschrieben. Figur 2A zeigt in einer schematischen Perspektivdarstellung einen ersten Verfahrensschritt dieses Verfahrens. Im Unterschied zum in Verbindung mit der Figur 1B beschriebenen Verfahrensschritt wird ein Wafer-Verbund 40 aus Halbleiterlaserchips 4 in diesem Ausführungsbeispiel mit seiner dem Wachstumssubstrat 41 abgewandten Oberfläche auf die mit Kontaktmetallisierungen 14 versehene Oberseite 31 einer Trägerscheibe 30 aufgebracht. Bei den Halbleiterlaserchips 4 handelt es sich dabei um so genannte "Bottom-Emitter" Strukturen. Der Wafer-Verbund 40 ist auf seiner der Trägerscheibe 30 zugewandten Oberfläche mit einer Lötmetallisierung versehen, welche auf die Kontaktmetallisierung 14 der Trägerscheibe aufgelötet beziehungsweise aufgebondet wird. Dabei kann die Kontaktmetallisierung 14, wie auch aus der Figur 2A ersichtlich ist, eine Strukturierung mit Trennbereichen zwischen Kontaktflächen aufweisen, um das nachfolgende Vereinzeln des Verbundes 70 aus Wafer-Verbund 40 und Trägerscheibe 30 zu erleichtern.

In einem nachfolgenden Verfahrensschritt wird das Wachstumssubstrat 41 beispielsweise durch selektives Nass- oder Trockenätzen entfernt. Ferner wird zwischen den einzelnen Halbleiterlaserchips 4 eine Mesa-Ätzung zur Erzeugung von Trennbereichen durchgeführt sowie anschließend eine entspiegelnde Passivierungsschicht auf die der Trägerscheibe 30 abgewandte Seite der Halbleiterlaserchips 4 aufgebracht, Figur 2B. Die Erzeugung der Mesa-Strukturen kann dabei alternativ schon vor dem Verbinden von Wafer-Verbund 40 und Trägerscheibe 30 zu einem Verbund 70 erfolgen.

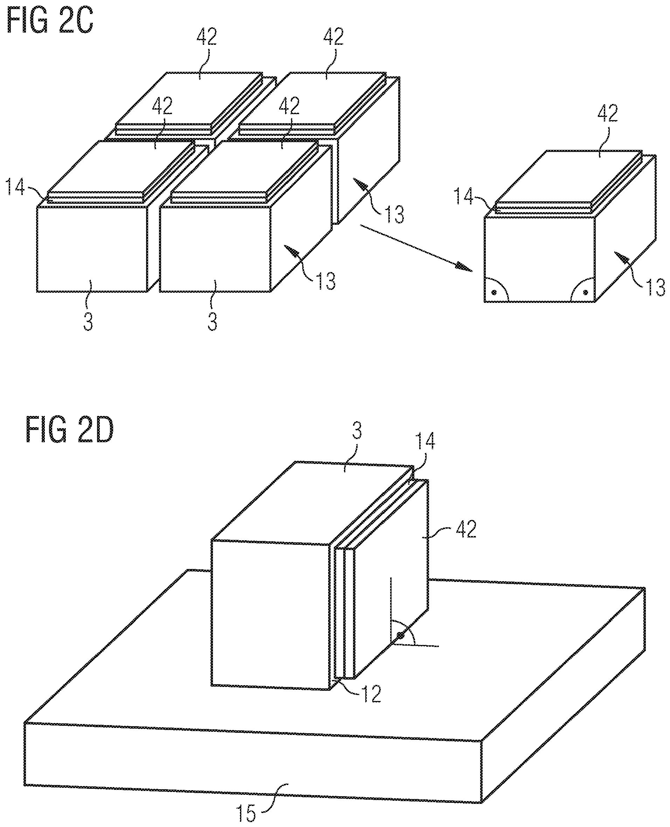

In den in Verbindung mit den Figuren 2C und 2D beschriebenen abschließenden Verfahrensschritten wird der Verbund, wie in Verbindung mit den Figuren 1C und 1D beschrieben, vereinzelt und einzelne Halbleiterlaser 100 werden auf Modulträger 15 montiert.

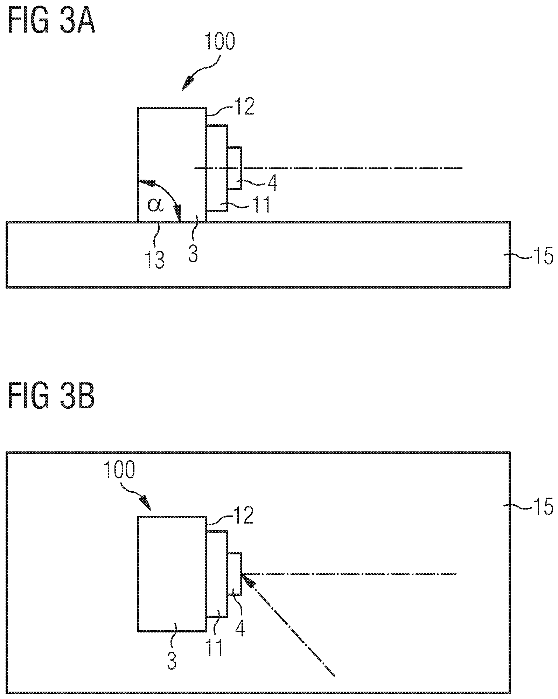

In Verbindung mit den Figuren 3A und 3B ist eine weitere hier beschriebene Halbleiterlaservorrichtung beschrieben. Die Figur 3A zeigt dabei eine schematische Schnittdarstellung, die Figur 3B zeigt eine schematische Draufsicht des Halbleiterlasers. Im Unterschied zu den in Verbindung mit den Figuren 1D und 2D beschriebenen Halbleiterlasern ist in diesem Ausführungsbeispiel zwischen dem Montageblock 3 und dem Halbleiterlaserchip 4 eine Wärmesenke 11 angeordnet, welche im Betrieb des Halbleiterlasers 100 den Wärmeabtransport vom Halbleiterlaserchip 4 zum Montageblock 3 hin verbessert. Die Wärmesenke wird dabei vor dem Aufbringen der Halbleiterlaserchips 4 auf die Trägerscheibe 30 aufgebracht und dort befestigt. Die Wärmesenken 11 können dabei als Scheibe im Verbund auf die Trägerscheibe 30 oder einzeln aufgebracht werden.

Darüber hinaus ist es in den in Verbindung mit den Figuren 1A bis 1D sowie 2A bis 2D beschriebenen Ausführungsbeispielen des Verfahrens zur Herstellung einer Vielzahl von Halbleiterlasern auch möglich, dass die Halbleiterlaserchips 4 nicht im Wafer-Verbund 40, sondern einzeln auf die Trägerscheibe 30 aufgebracht werden. Auch in diesem Fall verbleibt der Vorteil, dass die Vielzahl von Halbleiterlaserchips im Nutzen gefertigt werden kann. Darüber hinaus wird auch in diesem Fall eine besonders ebene Montagefläche durch die Vereinzelung der Trägerscheibe 30 erzeugt, welche im Wesentlichen senkrecht zur Oberseite 12 des Montageblocks 3 verläuft.

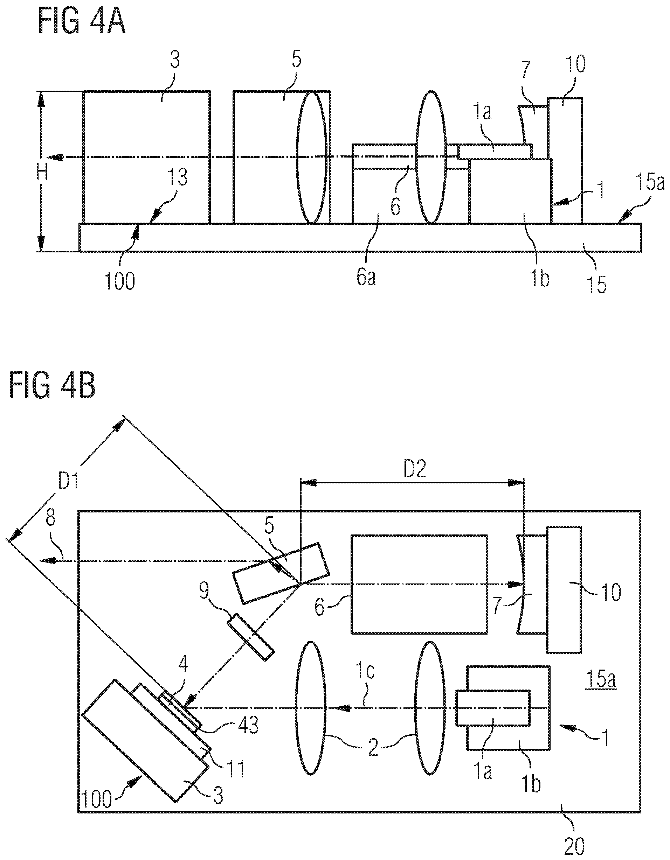

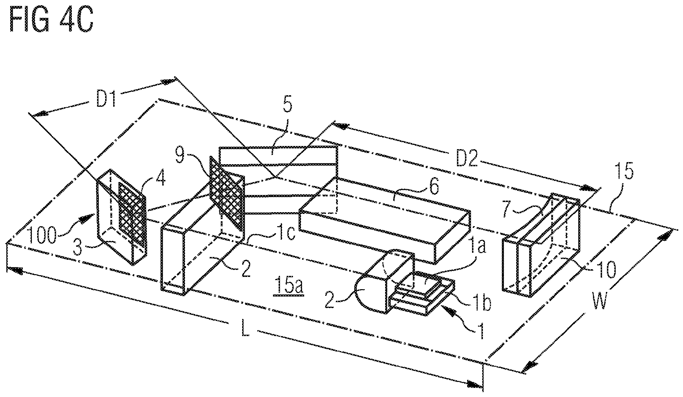

Anhand der Figuren 4A bis 4C ist der Einsatz eines hier beschriebenen Halbleiterlasers in einem Halbleiterlasermodul näher erläutert. Die Figur 4A zeigt das Halbleiterlasermodul gemäß dem ersten Ausführungsbeispiel in einer schematischen Seitenansicht. Die Figur 4B zeigt das Halbleiterlasermodul in einer schematischen Draufsicht. Die Figur 4C zeigt das Halbleiterlasermodul in einer schematischen Perspektivdarstellung. Das Halbleiterlasermodul umfasst einen Modulträger 15. Bei dem Modulträger 15 handelt es sich um eine Platte, die beispielsweise aus Direct Bonded Copper (DBC) besteht. Ferner ist es möglich, dass der Modulträger einen Grundkörper aus einem keramischen Material wie Aluminiumnitrid (AlN) aufweist, welcher an Oberseite und Unterseite Metallisierungen aufweist, die beispielsweise aus Kupfer bestehen und eine Dicke zwischen 0,1 und 0,3 vorzugsweise 0,2 mm aufweisen. Ferner kann der Modulträger Silizium enthalten oder aus diesem bestehen.

Der Modulträger 15 weist eine Montagefläche 15a auf, welche durch die Oberseite des Modulträgers 15 gebildet ist. Die Grundfläche der Montagefläche und damit die Grundfläche des Modulträgers 15 beträgt vorzugsweise höchstens 150 mm², besonders bevorzugt höchstens 100 mm². Beispielsweise weist die Montagefläche 15a eine Länge L von 11 mm auf und eine Breite W von 6 mm auf.

Auf die Montagefläche 15a sind die Komponenten des Halbleiterlasermoduls aufgebracht. Auf die Montagefläche 15a ist beispielsweise eine Pumpvorrichtung 1 aufgebracht. Die Pumpvorrichtung 1 umfasst eine Pumpquelle 1a und eine Wärmesenke 1b. Die Pumpquelle 1a ist auf der der Montagefläche 15a abgewanden Seite der Wärmesenke 1b befestigt. Die Wärmesenke 1b ist mit ihrer der Pumpquelle la abgewandten Seite auf die Montagefläche 15a aufgebracht, beispielsweise aufgelötet oder aufgeklebt. Die Pumpquelle 1a erzeugt stark divergentes Pumplicht. Bei der Pumpquelle 1a handelt es sich beispielsweise um einen kantenemittierenden Halbleiterlaser wie einen Breitstreifenlaser mit wenigstens einem Emitterbereich. Von der Pumpquelle im Betrieb erzeugte Pumpstrahlung wird durch die Pumpoptiken 2 auf den Halbleiterlaserchip 4 fokussiert.

Der Halbleiterlaserchip 4 ist Teil des Halbleiterlasers 100 wie er in Verbindung mit den Figuren 1A bis 1D, 2A bis 2C oder 3A, 3B näher erläutert ist. Der Halbleiterlaser 100 umfasst einen Montageblock 3, welcher mit seiner Montageflächen 13 auf der Montagefläche 15a des Modulträgers 15 befestigt, zum Beispiel angelötet oder angeklebt ist. Die Pumpstrahlung 1c ist derart durch die Pumpoptik 2 auf den Halbleiterlaserchip 4 fokussiert, dass dort ein Pumpspot mit einem Radius zwischen zirka 25 µm und höchstens 60 µm erzeugt wird. Bei dem Halbleiterlaserchip 4 handelt es sich um einen oberflächenemittierenden Halbleiterlaserchip (VECSEL), welcher durch die Pumpquelle 1a optisch gepumpt wird. Im Betrieb des Halbleiterlaserchips 4 erfolgt der Wärmefluss durch den Montageblock 3 um einen 90° Winkel zum Modulträger 15.

Der Resonator des Halbleiterlasermoduls ist durch einen Bragg-Spiegel 43 des Halbleiterlaserchips 4 und den Endspiegel 7 definiert. Die reflektierende Oberfläche des Endspiegels 7 umfasst dabei eine Beschichtung, die hoch reflektierend ist für die vom Halbleiterlaserchip erzeugte elektromagnetische Strahlung der Grundwellenlänge und eine Beschichtung die hoch reflektierend ist für die von der Frequenz-Konversions-Vorrichtung 6 wellenlängenkonvertierte elektromagnetische Strahlung. Der Halbleiterlaserchip 4 erzeugt dabei beispielsweise elektromagnetische Strahlung im Spektralbereich für Infrarotstrahlung, welche von der Frequenz-Konversions-Vorrichtung 6 zu elektromagnetischer Strahlung im Spektralbereich grünen Lichts konvertiert wird. Beispielsweise weist das Pumplicht eine Wellenlänge von 808 nm auf, der Halbleiterlaserchip 4 erzeugt Strahlung der Wellenlänge 1060 nm und die Frequenz-Konversions-Vorrichtung 6 erzeugt Strahlung der Wellenlänge 530 nm.

Das Halbleiterlasermodul weist eine Höhe H von höchstens 3,5 mm, vorzugsweise höchstens 3 mm, besonders bevorzugt höchstens 2,5 mm auf. Die Höhe H ist dabei der Abstand von der der Montagefläche 15a abgewandten Unterseite des Modulträgers 15 zum höchsten Punkt des Halbleiterlasermoduls welcher beispielsweise durch eine Komponente des Halbleiterlasermoduls wie den Halbleiterlaser 100 gebildet ist.

Der Resonator weist eine Länge D1 plus D2 auf, die höchstens 10 mm beträgt.

Im Resonator ist ein wellenlängenselektives Element, beispielsweise ein Etalon 9 angeordnet.

Ferner ist im Resonator die Frequenz-Konversions-Vorrichtung 6 angeordnet, welche einen optisch nicht-linearen Kristall umfasst. Darüber hinaus kann die Frequenz-Konversions-Vorrichtung 6 eine Heizvorrichtung 6a umfassen, welche zwischen dem optisch nicht-linearen Kristall und dem Modulträger 15 auf Montagefläche 15a angeordnet ist.

Die Auskopplung der frequenzkonvertierten Laserstrahlung 8 - also beispielsweise der grünen Laserstrahlung - erfolgt durch den Auskoppler 5, der zugleich als Faltungsspiegel zur Polarisationsselektion dient. Der Auskoppler 5 weist eine Beschichtung auf, welche für elektromagnetische Strahlung der Grundwellenlänge hoch reflektierend ist. Ferner weist der Auskoppler 5 eine Beschichtung auf, welche für frequenzkonvertierte Strahlung antireflektierend ausgebildet ist. Auf diese Weise wird elektromagnetische Strahlung der Grundwellenlänge im Resonator gehalten, wohingegen frequenzkonvertierte Strahlung 8 durch den Auskoppler 5 das Halbleiterlasermodul verlassen kann. Der Auskoppler 5 ist im vorliegenden Ausführungsbeispiel als Planspiegel für die elektromagnetische Strahlung der Grundwellenlänge ausgeführt. Der Endspiegel 7 ist beim in Verbindung mit den Figuren 4A bis 4C beschriebenen Ausführungsbeispiel auf einem Spiegel-Montageblock 10 angeordnet, der beispielsweise aus Silizium, Glas oder Aluminiumnitrid bestehen kann. Der Spiegel-Montageblock ist dabei optional.

Die Erfindung ist nicht durch die Beschreibung anhand der Ausführungsbeispiele beschränkt. Vielmehr ist ihr Umfang durch die beigefügten Ansprüche definiert.

## Patentansprüche

1. Verfahren zur Herstellung einer Vielzahl von Halbleiterlasern (100) mit den folgenden Verfahrensschritten:
a) Bereitstellen einer Trägerscheibe (30), die ein Halbleitermaterial oder ein Keramikmaterial enthält,
b) Herstellen eines Verbunds (70) durch Aufbringen einer Vielzahl von optisch pumpbaren Halbleiterlaserchips (4) im Wafer-Verbund (40) auf eine Oberseite (31) der Trägerscheibe (30),
c) Vereinzeln des Verbundes (70) zu einer Vielzahl von Halbleiterlasern (100) mittels Lasertrennen oder Wafersägen, wobei - jeder Halbleiterlaser (100) einen Montageblock (3) und zumindest einen Halbleiterlaserchip (4) umfasst,
- der Montageblock (3) aus einem Teil der ursprünglichen Trägerscheibe gebildet ist,
- jeder Montageblock (3) eine Montagefläche (13) aufweist, die im Wesentlichen senkrecht zu einer Oberseite (12) des Montageblocks (3) verläuft, auf welcher der Halbleiterlaserchip (4) angeordnet ist, und
- die Montagefläche (13) beim Vereinzeln des Verbunds erzeugt wird, wobei
- die Montagefläche (13) für die Montage auf einem Modulträger vorgesehen ist.

2. Verfahren nach dem vorherigen Anspruch, wobei nach dem Verfahrensschritt b) ein Wachstumssubstrat (41) von den Halbleiterlaserchips (4) entfernt wird.

3. Verfahren nach einem der vorherigen Ansprüche, wobei vor Verfahrensschritt b) für jeden Halbleiterlaserchip (4) eine Kontaktmetallisierung (14) auf die Oberseite (31) der Trägerscheibe (30) aufgebracht wird.

4. Verfahren nach einem der vorherigen Ansprüche, wobei vor Verfahrensschritt b) für jeden Halbleiterlaserchip (4) eine Wärmesenke (11) auf die Oberseite (31) der Trägerscheibe (30) aufgebracht wird.

5. Verfahren nach einem der vorherigen Ansprüche, wobei
- der Wafer-Verbund (40) einen Substrat-Wafer (41) umfasst, auf welchen eine Schichtenfolge (42), welche eine laseraktive Schicht umfasst, epitaktisch abgeschieden ist, wobei
- der Wafer-Verbund (40) mit dem Substratwafer (41) der Oberseite (31) der Trägerscheibe (30) zugewandt ist.

6. Verfahren nach einem der vorherigen Ansprüche, bei dem die Montagefläche (13) einen Winkelfehler von höchstens 0,3 Grad zu einer Oberseite (12) des Montageblocks (3) aufweist.

7. Halbleiterlaser der durch ein Verfahren nach einem der Ansprüche 1 bis 6 hergestellt ist, mit
- einem Montageblock (3), der eine Oberseite (12) und eine Montagefläche (13) aufweist,
- zumindest einem optisch pumpbaren Halbleiterlaserchip (4), der auf der Oberseite (12) des Montageblocks (3) angeordnet ist,
- wobei die Montagefläche (13) im Wesentlichen senkrecht zur Oberseite (12) des Montageblocks (3) verläuft und die Montagefläche (13) Vereinzelungsspuren aufweist, und wobei
- die Montagefläche (13) für die Montage auf einem Modulträger vorgesehen ist.

8. Halbleiterlaser nach dem vorherigen Anspruch, bei dem der Montageblock (3) eines der folgenden Materialen enthält oder aus einem der folgenden Materialien besteht: Halbleitermaterial, Keramikmaterial.

9. Halbleiterlaser nach einem der beiden vorherigen Ansprüche, bei dem
der Montageblock (3) eine im Wesentlichen gleichmäßige Dicke von wenigstens 0,5mm und höchstens 1,7 mm aufweist.

## Claims

1. Method for producing a plurality of semiconductor lasers (100) comprising the following steps:
a) providing a carrier wafer (30) containing a semiconductor material or a ceramic material,
b) producing a composite (70) by applying a plurality of optically pumpable semiconductor laser chips (4) in a wafer composite (40) to a top side (31) of the carrier wafer (30),
c) singulating the composite (70) to form a plurality of semiconductor lasers (100) by means of laser cutting or wafer sawing, wherein - each semiconductor laser (100) comprises a mounting block (3) and at least one semiconductor laser chip (4),
- the mounting block (3) is formed from a part of the original carrier wafer,
- each mounting block (3) has a mounting area (13) which runs substantially perpendicular to a top surface (12) of the mounting block (3), on which the semiconductor laser chip (4) is arranged; and
- the mounting area (13) is produced during singulation of the composite, wherein
- the mounting area (13) is intended for mounting on a module carrier.

2. Method according to the previous claim, wherein
a growth substrate (41) is removed from the semiconductor laser chips (4) after method step b).

3. Method according to one of the previous claims, wherein for each semiconductor laser chip (4), a contact metallization (14) is applied to the top side (31) of the carrier wafer (30) before method step b).

4. Method according to one of the previous claims, wherein for each semiconductor laser chip (4), a heat sink (11) is applied to the top side (31) of the carrier wafer (30) before method step b).

5. Method according to one of the previous claims, wherein
- the wafer composite (40) comprises a substrate wafer (41), on which a layer sequence (42) is epitaxially deposited comprising a laser-active layer, wherein
- the wafer composite (40) with the substrate wafer (41) faces the top side (31) of the carrier wafer (30).

6. Method according to one of the previous claims, wherein the mounting area (13) has an angular error of at most 0.3 degrees to a top surface (12) of the mounting block (3).

7. Semiconductor laser produced by a method according one of the claims 1 to 6, having
- a mounting block (3) having a top surface (12) and a mounting area (13),
- at least one optically pumpable semiconductor laser chip (4) arranged on the top side (12) of the mounting block (3),
- wherein the mounting area (13) runs substantially perpendicular to the top surface (12) of the mounting block (3) and the mounting area (13) has singulation traces, and wherein
- the mounting area (13) is intended for mounting on a module carrier.

8. Semiconductor laser according to the previous claim, in which
the mounting block (3) comprises or consists of one of the following materials: semiconductor material, ceramic material.

9. Semiconductor laser according to one of the two previous claims, in which
the mounting block (3) has a substantially uniform thickness of at least 0.5 mm and at most 1.7 mm.

## Revendications

1. Procédé de fabrication d'une pluralité de lasers à semi-conducteur (100) comprenant les étapes suivantes:
a) fournir une plaquette support (30) contenant un matériau semi-conducteur ou un matériau céramique,
b) produire un composite (70) en appliquant une pluralité de puces laser à semi-conducteur (4) pompables optiquement dans un composite de plaquette (40) sur une face supérieure (31) de la plaquette support (30),
c) séparer le composite (70) pour former une pluralité de lasers à semi-conducteur (100) au moyen d'une découpe au laser ou d'un sciage de plaquettes, dans lequel - chaque laser à semi-conducteur (100) comprend un bloc de montage (3) et au moins un puce laser à semi-conducteur (4),
- le bloc de montage (3) est formé à partir d'une partie de la plaquette support original,
- chaque bloc de montage (3) comporte une surface de montage (13) qui s'étend sensiblement perpendiculairement à une surface supérieure (12) du bloc de montage (3), sur laquelle le puce laser à semi-conducteur (4) est disposée; et
- la surface de montage (13) est produite pendant la séparation du composite, dans laquelle
- la surface de montage (13) est prévue pour le montage sur un support de module.

2. Procédé selon la revendication précédente, dans lequel un substrat de croissance (41) est retiré des puces laser à semi-conducteur (4) après l'étape b) du procédé.

3. Procédé selon l'une des revendications précédentes, dans lequel
une métallisation de contact (14) est appliquée sur la face supérieure (31) de la plaquette support (30) pour chaque puce laser à semi-conducteur (4) avant l'étape b) du procédé.

4. Procédé selon l'une des revendications précédentes, dans lequel
un dissipateur thermique (11) est appliqué sur la face supérieure (31) de la plaquette support (30) pour chaque puce laser à semi-conducteur (4) avant l'étape b) du procédé.

5. Procédé selon l'une des revendications précédentes, dans lequel
- le composite de plaquette (40) comprend une plaquette de substrat (41), sur laquelle une séquence de couches (42) est déposée épitaxialement comprenant une couche active au laser, dans lequel
- le composite de plaquette (40) avec la plaquette de substrat (41) fait face à la face supérieure (31) de la plaquette support (30).

6. Procédé selon l'une des revendications précédentes, dans lequel
la surface de montage (13) présente une erreur angulaire d'au plus 0,3 degré par rapport à une surface supérieure (12) du bloc de montage (3).

7. Laser à semi-conducteur produit par un procédé selon l'une des revendications 1 à 6, comportant
- un bloc de montage (3) ayant une surface supérieure (12) et une surface de montage (13),
- au moins un puce laser à semi-conducteur (4) pompable optiquement, disposée sur la face supérieure (12) du bloc de montage (3),
- dans laquelle la surface de montage (13) s'étend sensiblement perpendiculairement à la surface supérieure (12) du bloc de montage (3) et la surface de montage (13) présente des traces de séparation, et dans laquelle
- la surface de montage (13) est prévue pour le montage sur un support de module.

8. Laser à semi-conducteur selon la revendication précédente, dans lequel
le bloc de montage (3) comprend ou consiste en l'un des matériaux suivants: matériau semi-conducteur, matériau céramique.

9. Laser à semi-conducteur selon l'une des deux revendications précédentes, dans lequel
le bloc de montage (3) a une épaisseur sensiblement uniforme d'au moins 0,5 mm et d'au plus 1,7 mm.
